# DEMANDE DE BREVET EUROPEEN

(11) **EP 1 995 617 A1**
(43) Date de publication de la demande: **26.11.2008**
(21) Numéro de dépôt: 08154183.1
(22) Date de dépôt: 08.04.2008
(51) Int. Cl.: G02B 6/43

(54) **Dispositif optoélectronique compact incluant au moins un laser émettant par la surface**

(30) Priorité: 13.04.2007 FR 0754458
(71) Demandeur: Commissariat à l'Energie Atomique, 75015 Paris (FR)
(72) Inventeur: Kopp, Christophe, 38120 Fontanil-Cornillon (FR)
(74) Mandataire: Ilgart, Jean-Christophe

(57) **Abrégé**

Il s'agit d'un dispositif optoélectronique comportant au moins deux composants optoélectroniques (1, 2) qui coopèrent, parmi lesquels un premier qui est un laser à émission de lumière par la surface (1) et un autre composant optoélectronique (2). Chacun des composants optoélectroniques (1, 2) est monté sur une face principale (3.1, 3.2) différente et opposée d'une couche intermédiaire (3) incorporant un coupleur à réseau (5) couplé à un guide d'onde optique (4) destiné à véhiculer une partie de la lumière émise par le laser à émission par la surface (1). Le coupleur à réseau (5) est en sandwich entre la face émissive du laser à émission par la surface (1) et l'autre composant optoélectronique (2).

## Description

### DOMAINE TECHNIQUE

La présente invention est relative à un dispositif optoélectronique compact incluant au moins un laser émettant par la surface, dit VCSEL (acronyme anglo-saxon de Vertical Cavity Surface Emitting Laser) qui coopère avec un autre composant optoélectronique.

Elle s'applique en particulier à un laser à émission par la surface avec surveillance de la puissance qu'il émet ou coopérant avec un autre émetteur pour réaliser une fonction de multiplexage optique dans un guide d'onde optique.

Le développement des composants optoélectroniques laser à émission par la surface a ouvert un vaste de champ d'applications allant de la détection de gaz à la réalisation de modules optoélectroniques pour réseaux à fibres optiques en réseaux à courtes distances. Les lasers à émission par la surface présentent un certain nombre d'atouts par rapport aux lasers à émission par la tranche dits EEL (acronyme anglo-saxon de Edge Emitting Laser), en particulier leur aptitude à être testés collectivement sur le substrat commun sur lequel ils sont fabriqués et leur plus grande facilité de couplage dans des fibres optiques standard.

L'utilisation de ces lasers à émission par la surface se fait après mise en boîtier, traditionnellement des boîtiers dits TO (acronyme anglo-saxon de Transistor Outline) ou des boîtiers dits TOSA (acronyme anglo-saxon de Transmitter Optical Sub Assembly), munis respectivement d'une fenêtre laissant passer le faisceau lumineux émis ou d'un dispositif permettant la connexion électrique d'un connecteur à fibre optique.

### ÉTAT DE LA TECHNIQUE ANTÉRIEURE

La plupart des applications mettant en oeuvre ces lasers à émission par la surface nécessitent de pouvoir mesurer en permanence la puissance émise par le laser grâce à un photodétecteur placé à l'intérieur du boîtier. Le photodétecteur est typiquement une photodiode de type PIN appelée aussi photodiode de surveillance. On cherche donc à illuminer le photodétecteur avec une fraction de la lumière émise par le laser avant qu'elle ne s'échappe du boîtier.

Contrairement aux lasers à émission par la tranche, il n'est pas possible de placer le photodétecteur sur la face du laser opposée à celle qui produit la lumière car cette face est celle d'un substrat sur lequel a été effectuée la croissance par épitaxie de la structure intrinsèque du laser et que ledit substrat est opaque à la lumière produite par le laser.

Les courants nécessaires pour faire cette surveillance sont de l'ordre d'environ 100 à 500 micro ampères avec des traitements capables de détecter des variations de courants très faibles. Ainsi avec des photodiodes dont la sensibilité typique est inférieure à environ 1 A/W et des lasers à émission par la surface de puissance de l'ordre de 1 à 2 mW, il peut être nécessaire de prélever jusqu'à environ 50% de la lumière émise par le laser pour la surveillance, les autre 50 % pouvant être utilisés pour l'application choisie.

La surveillance s'effectue conventionnellement en tirant partie de réflexions parasites du faisceau lumineux émis par le laser sur la fenêtre de sortie du boîtier. En effet une fraction du faisceau est réfléchie et une photodiode de surveillance peut être placée sur le trajet de la portion de faisceau après réflexion.

Dans le brevet US-B-5 905 750, le photodétecteur et la surface d'émission du laser sont côte à côte, ils sont placés sensiblement dans un même plan.

Dans la demande de brevet GB-A-2 351 180, le laser surmonte la puce sur laquelle se trouve le photodétecteur, le laser et le photodétecteur étant décalés latéralement l'un par rapport à l'autre.

Dans le brevet américain US-B-5 737 348 le laser surmonte le photodétecteur, il est placé dans une zone centrale du photodétecteur. La collecte ne peut se faire que dans une zone périphérique du photodétecteur.

Dans la demande de brevet WO-A-99/34487 le laser et le photodétecteur sont agencés comme dans la demande de brevet GB-A-2 351 180 et la fenêtre est inclinée par rapport à l'axe d'émission du faisceau laser de manière à rediriger la partie du faisceau qui se réfléchit sur le photodétecteur.

Dans le brevet US-B-5 943 357 le photodétecteur et le laser sont empilés et le photodétecteur ne reçoit que de la lumière émise par l'arrière du laser.

Dans le brevet américain US-B-5 757 836 le photodétecteur se trouve à côté du laser, sa face sensible est sensiblement transversale à la face avant du laser.

Dans le brevet EP-A-0 869 590, la demande de brevet WO-A-03/000019 et la demande de brevet US-A-2003/0109142, le photodétecteur est soit sur le trajet du faisceau direct émis par le laser, soit sur le trajet d'une fraction réfléchie, la face avant du laser et la face sensible du photodétecteur étant dans des plans distincts.

Un inconvénient de ces structures est que leur emprise au sol est importante, car le photodétecteur côtoie latéralement la face avant du laser. Cet inconvénient existe également dans des dispositifs optoélectroniques comportant un laser à émission en surface qui est associé à un autre composant optoélectronique qui ne serait pas photodétecteur mais émetteur. Un tel dispositif optoélectronique comporte de plus un multiplexeur pour combiner les faisceaux émis par les deux sources de lumière et faire du multiplexage.

Dans les trois dernières structures citées l'encombrement est aussi important en épaisseur.

Les structures pour lesquelles la surveillance se fait sur une fraction du faisceau émis par le laser, cette fraction étant réfléchie par une fenêtre, ne donnent pas toute satisfaction car la puissance surveillée n'est pas assez importante et le rapport signal sur bruit est trop faible.

De plus, lorsque le dispositif comporte plusieurs lasers dans un même boîtier, et que la surveillance se fait sur des faisceaux réfléchis, il n'est pas possible de discriminer les puissances respectives des différents lasers.

### EXPOSÉ DE L'INVENTION

La présente invention a justement comme but de proposer un dispositif optoélectronique qui ne présente pas les inconvénients mentionnés ci dessus.

Un but est en particulier de proposer un tel dispositif optoélectronique qui présente une forte compacité par rapport à l'art antérieur.

Un autre but de la présente invention est de proposer un dispositif optoélectronique qui comporte un laser à émission par la surface coopérant avec un composant qui est un photodétecteur de surveillance dans lequel la puissance qui est surveillée par le photodétecteur est accrue par rapport à l'art antérieur, cette surveillance permettant de détecter un éventuel dysfonctionnement du laser et/ou de réguler la puissance moyenne émise.

Un autre but de l'invention est de fournir un dispositif optoélectronique avec un laser à émission par la surface qui coopère avec un photodétecteur dans lequel la représentativité du niveau de puissance est accrue par rapport à l'art antérieur.

Pour atteindre ces buts l'invention concerne plus précisément un dispositif optoélectronique comportant au moins deux composants optoélectroniques qui coopèrent, parmi lesquels un premier qui est un laser à émission de lumière par la surface et un autre composant optoélectronique, caractérisé en ce que chacun des composants optoélectroniques est monté sur une face principale différente et opposée d'une couche intermédiaire incorporant un coupleur à réseau couplé à un guide d'onde optique destiné à véhiculer une partie de la lumière émise par le laser à émission par la surface, le coupleur à réseau étant en sandwich entre la face émissive du laser à émission par la surface et l'autre composant optoélectronique.

L'autre composant optoélectronique peut être un photodétecteur de surveillance de la lumière émise par le laser.

En variante, l'autre composant optoélectronique peut être un émetteur destiné à faire du multiplexage avec le laser à émission par la surface.

Le coupleur à réseau est semi-transparent pour la lumière émise par le laser à émission par la surface, notamment lorsque l'autre composant optoélectronique est un photodétecteur.

La couche intermédiaire peut être flanquée sur chacune des ses faces principales de pistes de connexion électrique.

Au moins une piste de connexion électrique se termine par un plot doté d'une bille fusible avant le montage du laser ou de l'autre composant optoélectronique.

Une piste de connexion électrique d'une face de la couche intermédiaire peut être reliée à une piste de connexion électrique de l'autre face de la couche intermédiaire par au moins un trou métallisé traversant la couche intermédiaire.

Un boîtier peut loger la couche intermédiaire et au moins une paire formée du laser et de l'autre composant optoélectronique.

Lorsque plusieurs paires sont logées dans le boîtier, les composants optoélectroniques montés sur une face de la couche intermédiaire peuvent être individuels ou regroupés en barrette.

La présente invention concerne également un procédé de réalisation d'un dispositif optoélectronique comportant au moins deux composants optoélectroniques qui coopèrent parmi lesquels un premier qui est un laser à émission de lumière par la surface et un autre composant optoélectronique comportant les étapes suivantes :
- réalisation sur un substrat de base d'une couche intermédiaire incorporant un coupleur à réseau couplé à un guide d'onde optique et ayant une face principale libre,
- réalisation de pistes de connexion électrique sur la face principale libre de la couche intermédiaire,
- assemblage de l'un des deux composants optoélectroniques sur la face principale libre de la couche intermédiaire en le plaçant au niveau du coupleur de réseau et en le reliant électriquement aux pistes de connexion électrique,
- dépôt d'un enrobé sur la face principale libre de la couche intermédiaire englobant le composant optoélectronique assemblé,
- élimination du substrat de base mettant à nu une autre face principale de la couche intermédiaire,
   réalisation de pistes de connexion électrique sur la face principale mise à nu de la couche intermédiaire,
- assemblage de l'autre composant optoélectronique sur la face principale mise à nu de la couche intermédiaire en le plaçant au niveau du coupleur de réseau et en le reliant électriquement aux pistes de connexion électrique de la face principale mise à nu.

Dans le procédé, l'assemblage peut se faire par connexion par billes fusibles, par thermo-compression de plots ou par collage avec de la colle conductrice.

De la colle peut être insérée entre la couche intermédiaire et l'un au moins des composants optoélectroniques.

Le coupleur à réseau et le guide d'onde optique peuvent être réalisés en surface du substrat de base.

Le guide d'onde optique peut avoir un coeur qui est réalisé, tout comme le coupleur à réseau, en silicium, silice dopée, matériau obtenu par sol-gel, résine, polymère.

L'élimination du substrat de base peut se faire par gravure chimique sélective.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
la figure 1 montre une coupe d'un exemple de dispositif optoélectronique selon l'invention ;
les figures 2A, 2B, 2C montrent, en vue de dessus et/ou de dessous des dispositifs optoélectroniques de l'invention logés dans un boîtier ;
les figures 3A à 3H montrent des exemples d'étapes de réalisation de la couche intermédiaire, des pistes conductrices et des plots de connexion du dispositif optoélectronique de l'invention ;
les figures 4A à 4I montrent des exemples d'étapes d'hybridation d'un composant optoélectronique du dispositif optoélectronique de l'invention ;
les figures 5A à 5D montrent des exemples d'étapes d'hybridation de l'autre composant optoélectronique du dispositif optoélectronique de l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes variantes représentées doivent être comprises comme n'étant pas forcément exclusives les unes des autres.

Des structures bien connues ne sont pas représentées en détail afin de ne pas alourdir inutilement la présente invention.

### EXPOSÉ DÉTAILLÉ DE MODES DE RÉALISATION PARTICULIERS

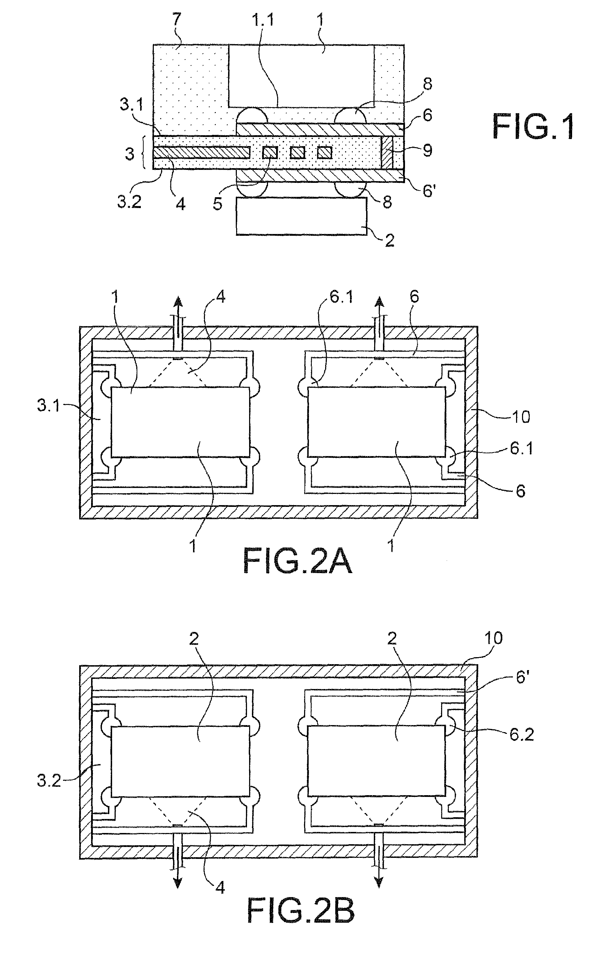

On va maintenant s'intéresser à la figure 1 qui montre un dispositif optoélectronique incluant deux composants optoélectroniques parmi lesquels un laser à émission de lumière par la surface et un autre composant optoélectronique. Le laser est référencé 1 et l'autre composant optoélectronique 2. Les deux composants optoélectroniques 1, 2 coopèrent l'un avec l'autre. L'autre composant optoélectronique 2 peut être un photodétecteur de surveillance, par exemple une diode PIN, ou d'un émetteur optique, par exemple un autre laser émettant par la surface, une diode laser ou autre.

Dans la suite de la description, on parlera d'autre composant optoélectronique 2 de manière générale.

Le laser à émission par la surface 1 et l'autre composant optoélectronique 2 sont montés de part et d'autre d'une couche intermédiaire 3 incorporant un guide d'onde optique 4 et un coupleur à réseau 5 (grating coupler en anglais). La face du laser 1 qui émet de la lumière est référencée 1.1, elle se trouve du côté de la couche intermédiaire 3.

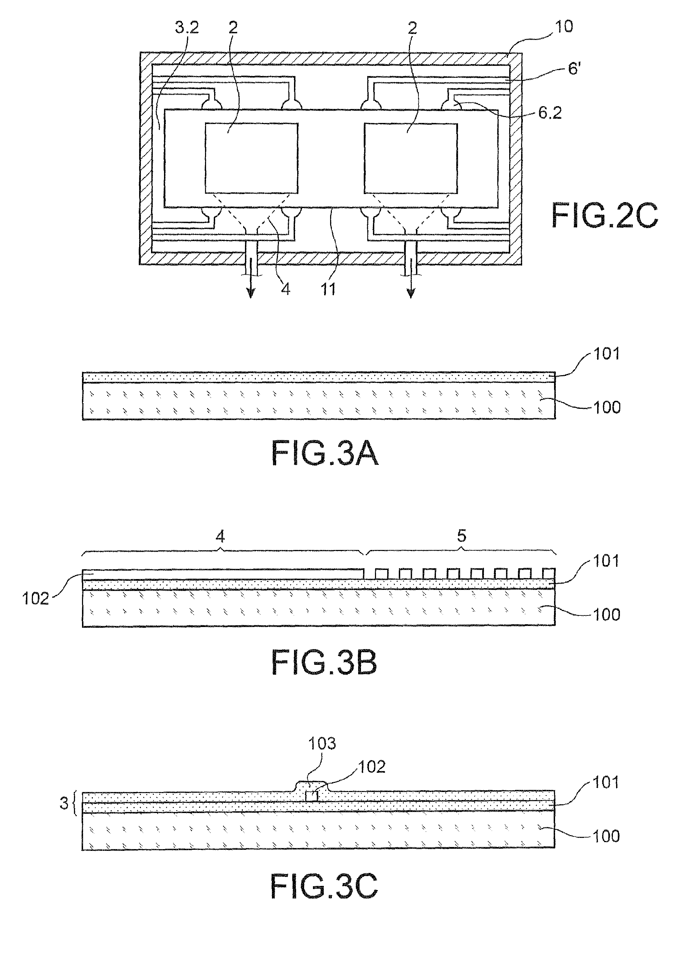

Le guide d'onde optique 4 est destiné à transporter une partie de la lumière émise par le laser à émission par la surface 1 vers un dispositif utilisateur (non représenté). Le guide d'onde optique 4 a une extrémité couplée au coupleur à réseau 5 et une extrémité libre par laquelle sort la lumière que le guide d'onde optique 4 a véhiculée. Le coupleur à réseau 5 est situé en amont du guide d'onde optique 4, en vis-à-vis de la face émettrice 1.1 du laser 1. Le coupleur à réseau 5 peut être par exemple un réseau de diffraction, un réseau de Bragg ou autre. Les coupleurs à réseaux sont des structures bien connues en optique. Ils comportent une structure périodique de type réseau qui permet d'injecter une partie de la lumière qu'ils reçoivent de manière sensiblement perpendiculaire ou inclinée dans le guide d'onde optique qui leur est couplé et qui se trouve dans le prolongement du coupleur à réseau, sensiblement dans le même plan. La structure périodique est bien visible sur la figure 3B. On peut se référer à l'article « Silicon-on-insulator nanophotonics de W. Boagerts et al. Proceedings of SPIE, Integrated Optics : Theory and Applications, 31 août 2005 à 2 septembre 2005, Varsovie, Pologne, T. 2005, Vol. 5956 » qui montre des coupleurs à réseaux pour le couplage de lumière dans un guide d'onde optique. L'autre partie de la lumière émise par le laser 1 traverse le coupleur à réseau 5 qui est semi-transparent, et atteint l'autre composant optoélectronique 2. S'il s'agit d'un photodétecteur, ce dernier peut surveiller l'émission du laser 1. Si l'autre composant optoélectronique 2 est un émetteur, le coupleur à réseau 5 est aussi semi-transparent.

Typiquement le taux de couplage de la lumière émise par le laser 1 dans le guide d'onde optique 4 est d'environ 50 à 80%.

Lorsque l'autre composant optoélectronique 2 est un autre laser à émission par la surface, il est symétrique du premier laser 1 par rapport au coupleur à réseau 5. Sa face qui émet la lumière est en vis-à-vis du coupleur à réseau 5.

La référence 7 indique un enrobé qui entoure le laser à émission par la surface 1. On décrira son utilité par la suite.

Le laser à émission par la surface 1 et l'autre composant optoélectronique 2 sont montés ou hybridés sur la couche intermédiaire 3, en prenant en sandwich le coupleur à réseau 5. Le montage peut se faire par des billes 8 de matériau fusible à appliquer sur des plots de connexion 6.1, 6.2 (visibles sur les figures 2) ou des pistes conductrices 6, 6' cette technique de montage étant connue sous la technique d'assemblage dite « flip-chip », soit connexion par billes, ou dite C4 chez IBM, le terme C4 étant l'acronyme anglo-saxon de « Controlled Collapse Chip Connexion » en français on parle plutôt de brasage par bille fusible.

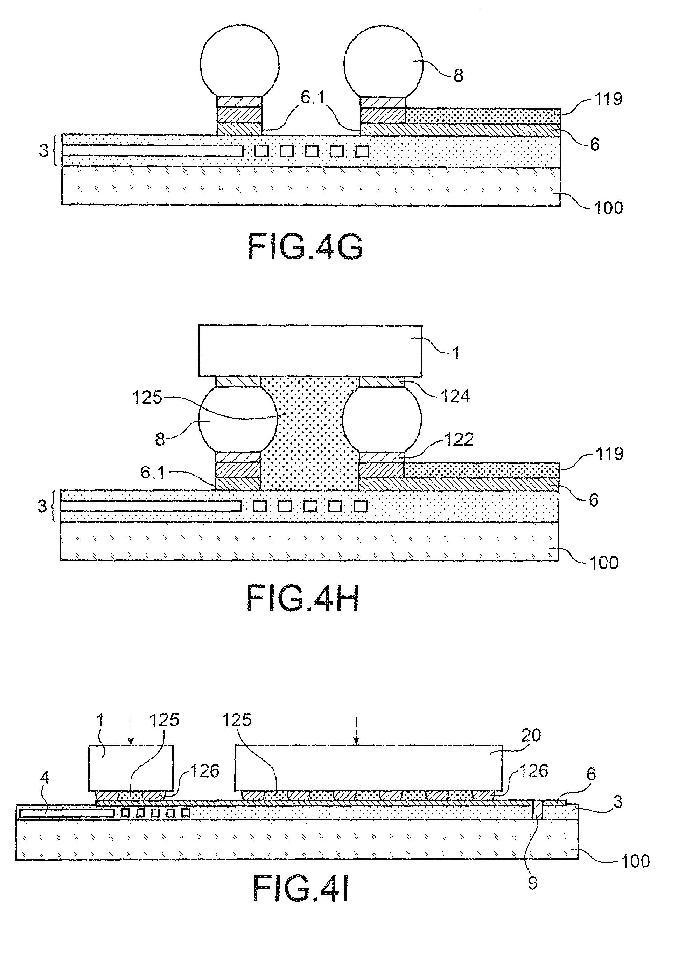

En variante, il est possible de réaliser une thermo-compression de plots de connexion métalliques 126 ou un collage grâce à des plots de résine conductrice déposées par exemple par sérigraphie. On suppose que sur la figure 4I, les plots 126 représentent indifféremment les plots métalliques ou les plots de résine conductrice.

Les billes 8 peuvent être portées soit par le laser ou l'autre composant optoélectronique soit par la couche intermédiaire 3 avant l'hybridation.

Le laser à émission par la surface 1 et l'autre composant optoélectronique 2 ont besoin d'être reliés à des pistes de connexion électrique 6, 6' d'une part pour leur alimentation en énergie ainsi que pour leur commande ou pour récupérer les signaux électriques qu'ils génèrent dans le cas d'un photodétecteur 2. On prévoit de placer sur chacune des faces principales 3.1, 3.2 de la couche intermédiaire 3 sur lesquelles sont montés le laser à émission par la surface 1 et l'autre composant optoélectronique 2, ces pistes conductrices, par exemple agencées en réseau. Une piste de connexion électrique 6 d'une face 3.1 peut être reliée à une piste de connexion électrique 6' de l'autre face 3.2 par l'intermédiaire d'un trou métallisé 9 ou via. Ces pistes de connexion électrique 6, 6' peuvent se terminer par des plots de connexion 6.1, 6.2 sur lesquels sont réalisées les billes fusibles 8 pour l'hybridation du laser à émission par la surface 1 et de l'autre composant optoélectronique 2.

La couche intermédiaire 3 peut être réalisée à base de silicium ou de silice par exemple, comme on le verra ultérieurement.

Le dispositif optoélectronique objet de l'invention est particulièrement bien adapté au cas où il comporte, dans un même boîtier 10, plusieurs lasers à émission par la surface 1 qui coopèrent chacun avec un composant optoélectronique 2 de type photodétecteur. Chacun des photodétecteurs 2 surveille la puissance émise par le laser 1 qui coopère avec lui à travers la couche intermédiaire 3. Les lasers 1 d'une part et les composants optoélectroniques 2 d'autre part peuvent se présenter de manière unitaire et être assemblés individuellement sur la couche intermédiaire 3 comme illustré sur les figures 2A, 2B ou bien se présenter groupés en barrette 11 comme illustré sur la figure 2C. La figure 2A est une vue de dessus du dispositif optoélectronique côté laser 1, tandis que les figures 2B, 2C sont des vues de dessous du dispositif optoélectronique, c'est-à-dire du côté de l'autre composant optoélectronique 2. Le boîtier 10, les pistes de connexion électrique 6 ou 6' et les plots de connexion 6.1 ou 6.2 sont visibles selon la vue. Le guide d'onde optique 4 est esquissé.

En se basant sur les figures 2A, 2B, on peut placer ainsi dans le boîtier 10, en parallèle, douze lasers 1, émettant chacun un faisceau multimode, ces faisceaux ayant tous la même direction privilégiée. Ces lasers 1 peuvent être des lasers à émission par la surface en arséniure de gallium dont la longueur d'onde est 850 nanomètres. Cela correspond au standard SNAP 12 portant sur une norme commune pour des modules enfichables à fibres optiques de 12 canaux. Les sorties optiques du dispositif optoélectronique selon l'invention peuvent être directement couplées dans des guides d'onde optiques multimode des circuits imprimés optiques pour des liaisons entre cartes.

On va maintenant s'intéresser à un exemple de procédé de fabrication d'un dispositif optoélectronique de l'invention.

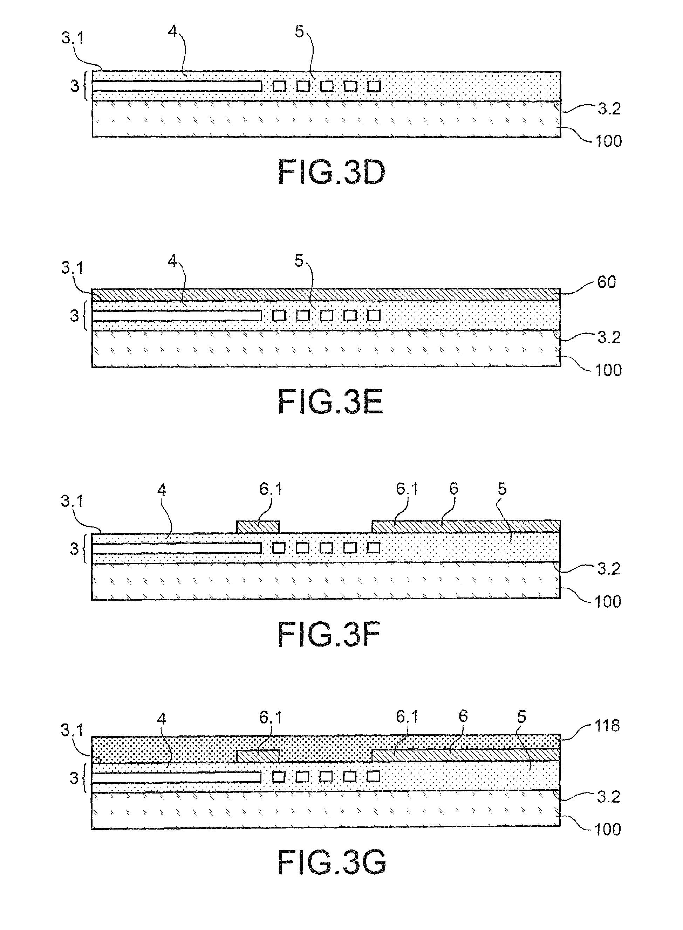

On part d'un substrat de base 100, par exemple en silicium, sur lequel on va former le guide d'onde optique 4 et le coupleur à réseau 5. Cette formation est réalisée par une suite d'étapes de dépôt ou de formation et de micro structurations. Si le guide d'onde optique 4 est réalisé en surface, on peut commencer par déposer, sur le substrat de base 100, par exemple par PECVD (acronyme de Plasma enhanced chemical vapor deposition soit dépôt chimique en phase vapeur assisté par plasma) une couche de gaine inférieure 101, par exemple en silice, pour le guide d'onde optique (figure 3A). On réalise ensuite le coeur 102 du guide d'onde optique en déposant, par exemple par PECVD, une couche de silicium, de silice dopée au phosphore, au bore ou au germanium par exemple, de résine, de polymère. On délimite ensuite les contours du coeur 102 par photolithographie suivie d'une gravure (figure 3B). On délimite en même temps les motifs du coupleur à réseau 5 à une extrémité du coeur 102. On dépose ensuite, par exemple par PECVD une seconde couche de gaine 103, par exemple en silice, sur le coeur 102, le coupleur à réseau 5 et la première couche de gaine 101 (figure 3C). La figure 3C est une coupe transversale du guide d'onde optique 4 et la figure 3D une coupe longitudinale. On pourrait également procéder à partir d'un substrat semi-conducteur sur isolant connu sous l'acronyme SOI soit silicon-on-insulator en anglais comme décrit dans l'article cité au début.

Pour des applications de guide d'onde optique multimode, les guides d'onde optiques dont au moins le coeur est obtenu par le procédé sol-gel, en résine et en polymère sont préférés.

On a ainsi réalisé la couche intermédiaire 3. Elle possède une face principale 3.1 qui est libre et une autre face principale 3.2 qui est solidarisée au substrat de base 100 et qui sera mise à nu ultérieurement.

On réalise ensuite sur la face principale libre 3.1 de la couche intermédiaire 3, les pistes de connexion électrique 6 appropriées au composant optoélectronique que l'on va assembler à cette face libre 3.1 de la couche intermédiaire 3, et éventuellement les plots de connexion 6.1 qui terminent ces pistes de connexion électrique 6 et servent à l'assemblage du composant optoélectronique. Le composant optoélectronique peut être le laser à émission par la surface 1 mais on peut envisager que ce soit l'autre composant optoélectronique 2 qui soit assemblé à cette face libre 3.2. Dans la suite de la description on suppose que c'est le laser que l'on va assembler en premier mais ce n'est pas limitatif.

Les pistes de connexion électrique 6 peuvent être réalisées de manière conventionnelle à base de métal tel que de l'aluminium qui est le métal le plus utilisé, du cuivre, de l'or, de l'argent par exemple par PVD (acronyme anglo-saxon de plasma vapor deposition soit dépôt en phase vapeur par plasma). On dépose le métal 60 et par photolithographie et gravure on délimite le contour des pistes de connexion électrique 6 ainsi que celui des plots de connexion 6.1 (figures 3E, 3F).

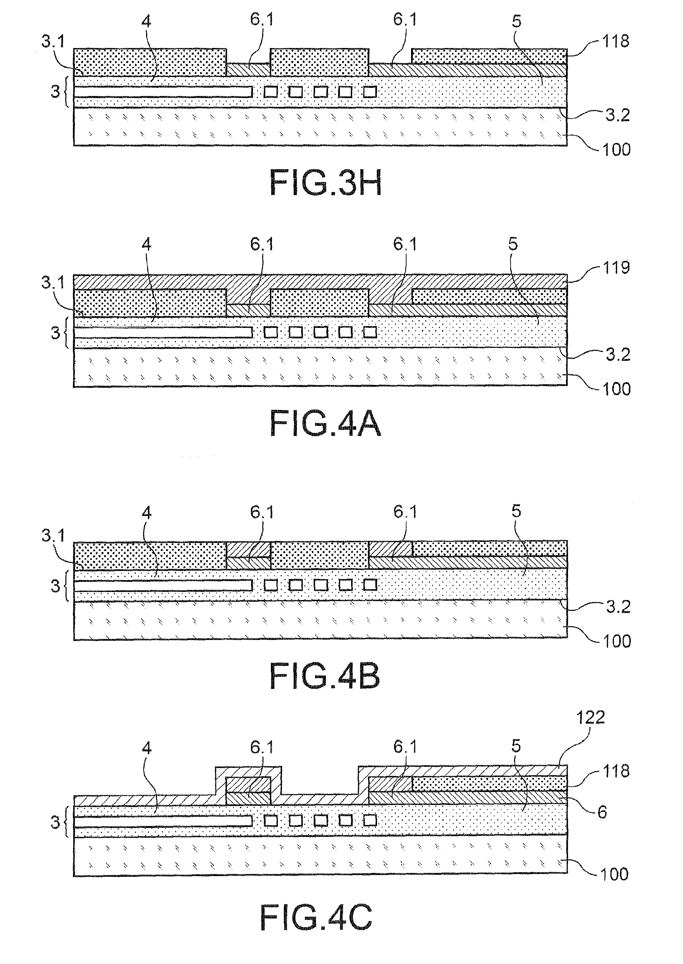

Ensuite, on recouvre l'ensemble d'une couche de passivation électriquement isolante 118, par exemple en SiO₂ ou en Si₃N₄, par PECVD (figure 3G). Cette couche de passivation 118 isolante va être gravée au niveaux des plots 6.1 de manière à mettre à les mettre à nu (figures 3H). La gravure peut être de type RIE (acronyme de reactive ion etching soit gravure plasma) par exemple. Si on utilise un assemblage par thermo-compression, on s'arrête là puisqu'on n'utilise pas de billes fusibles.

On suppose que dans l'exemple décrit, les pistes 6 seront réalisées en même temps que les plots 6.1 équipés de billes fusibles 8.

On va voir maintenant comment réaliser des plots de connexion 6.1 équipés de billes fusibles 8 pour assembler le laser 1 à la couche intermédiaire 3 par connexion avec billes (procédé flip-chip). En qualifiant de « fusibles » les billes, on veut dire qu'elles sont réalisées dans un matériau apte à fondre à des températures suffisamment basses permettant de ne pas endommager le composant à assembler à l'aide des billes.

Les plots de connexion 6.1 équipés des billes fusibles 8 sont placés soit en surface de la couche intermédiaire 3, soit sur le laser 1 ou sur l'autre composant optoélectronique 2. S'ils sont réalisés sur la couche intermédiaire 3, ils sont placés en contact électrique avec les pistes de connexion électrique 6, 6'.

Lors de l'assemblage, la face émissive du laser 1 vient en regard du coupleur à réseau 5. En ce qui concerne l'autre composant optoélectronique 2, s'il s'agit d'un photodétecteur, sa face sensible vient en regard du coupleur à réseau 5 et s'il s'agit d'un émetteur, c'est sa face émissive qui est en regard du coupleur à réseau 5.

Le composant optoélectronique 1, 2 comportera également des plots de connexion dotés ou non de billes fusibles, puisque les billes fusibles 8 sont localisées soit sur la couche intermédiaire 3 soit sur le composant optoélectronique 1, 2 avant l'hybridation.

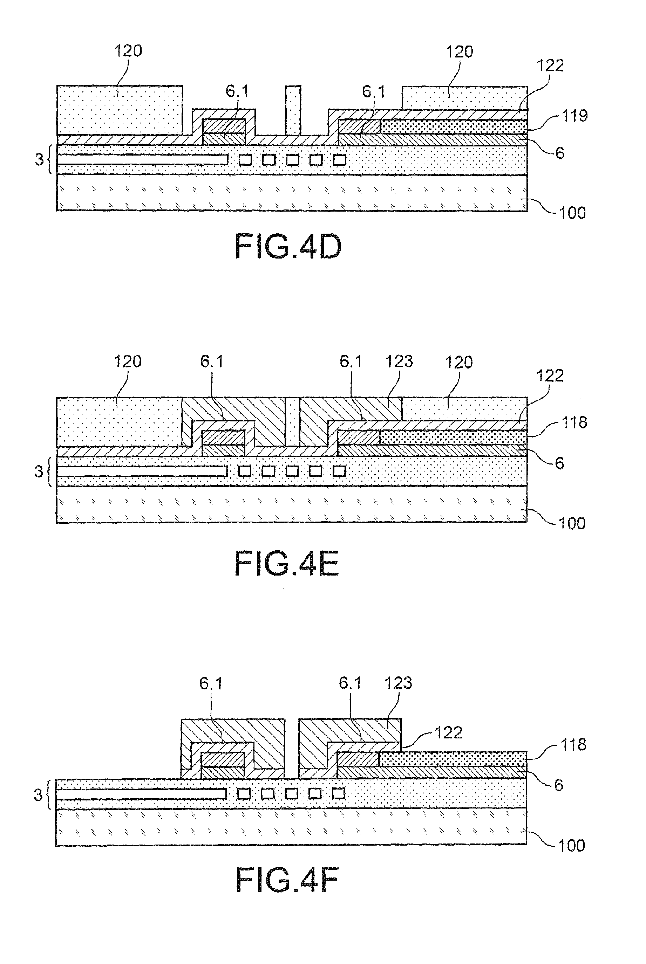

Dans l'exemple décrit aux figures 3 et 4, on suppose que l'on réalise les plots 6.1 dotés des billes fusibles 8 sur la couche intermédiaire 3. Ce n'est pas limitatif, le procédé serait le même pour les réaliser sur le composant. On suppose que l'on réalise en même temps que les plots de connexion 6.1, les pistes de connexion électrique 6. Sur les plots 6.1 de la couche intermédiaire 3, on va former un dépôt de métal d'accrochage 119, généralement multicouche par exemple un multicouche titane-nickel-or (figure 4A). Par photolithographie suivie d'une gravure (figure 4B) dans le métal d'accrochage 119, on va délimiter le métal d'accrochage 119 au contour des plots de connexion 6.1. On suppose que le plot de connexion de droite 6.1 se trouve à une extrémité de la seule piste de connexion électrique 6 visible sur les figures 4. Il y a un autre plot de connexion 6.1 à gauche.

On va réaliser les billes fusibles 8 au niveau des plots de connexion 6.1. On va déposer un fond continu 122 en surface (figure 4C), par exemple en titane par PVD. Il sert de contact électrique pour un dépôt par électrolyse.

On va ensuite réaliser par photolithographie des caissons à l'aide de résine 120, au niveau des plots de connexion 6.1, devant recevoir le matériau fusible des billes (figure 4D).

On remplit les caissons de matériau fusible 123 (figure 4E), cela peut se faire par croissance électrolytique. Le matériau peut être par exemple un alliage plomb-étain, de l'indium. Après solidification, on élimine les caissons 120 et le matériau du fond continu 122, rendu accessible par l'élimination des caissons (figure 4F). On chauffe de manière à obtenir la fusion du matériau fusible 123 et son regroupement sous forme des billes fusibles 8 (figure 4G).

Le laser 1 hybridé comporte lui aussi des plots de connexion métalliques qui doivent être solidarisés aux billes fusibles 8. Ils sont référencés 124 sur la figure 4H. En chauffant et en réalisant une re-fusion du matériau fusible des billes 8, on relie mécaniquement et électriquement le laser 1 à la couche intermédiaire 3 au niveau des pistes de connexion électrique 6 qu'elle porte (figure 4H). Une fois les billes fusibles solidifiées 8, la tension de surface du matériau fusible provoque un alignement automatique du laser 1 par rapport aux plots de connexion 6.1 de la couche intermédiaire 3. Les billes fusibles 8 assurent à la fois le positionnement mécanique et la connexion électrique du laser 1 ainsi rapporté. L'utilisation de la technique de report par retournement et connexion par billes est motivée d'une part ses bonnes performances hyperfréquences et par ses propriétés d'auto-alignement, des précisions de l'ordre de quelques microns voire moins du micron peuvent être obtenues. On réalise ainsi un alignement passif du laser 1 et de la couche intermédiaire 3.

Il est possible de solidariser un autre composant 20 sur la même face libre 3.1 de la couche intermédiaire 3 que celle qui accueille le laser 1. Il peut s'agir par exemple d'un dispositif de pilotage 20 du laser 1 montré sur la figure 4I. La description qui vient d'être faite concerne le montage du laser 1 mais on pourra procéder de la même manière pour le montage de l'autre composant optoélectronique 2 sur l'autre face principale de la couche intermédiaire. C'est pourquoi on ne décrira pas et n'illustrera pas à nouveau cette réalisation.

Au lieu d'utiliser une technique de connexion par billes classique, on peut utiliser une technique d'assemblage par plots métalliques 126 et thermo-compression comme illustré sur la figure 4I.

On peut, de plus dans les deux cas, disposer de la colle 125 entre le laser 1 et la couche intermédiaire 3 pour éviter des problèmes de dilatation thermique.

En variante, il est possible que l'assemblage se fasse par des plots de connexion en résine conductrice électriquement au lieu d'utiliser des plots métalliques et éventuellement les billes fusibles. Ces résines peuvent être chargées à l'argent, au palladium, au platine par exemple. On pourra aussi placer de la colle transparente entre le laser et la couche intermédiaire.

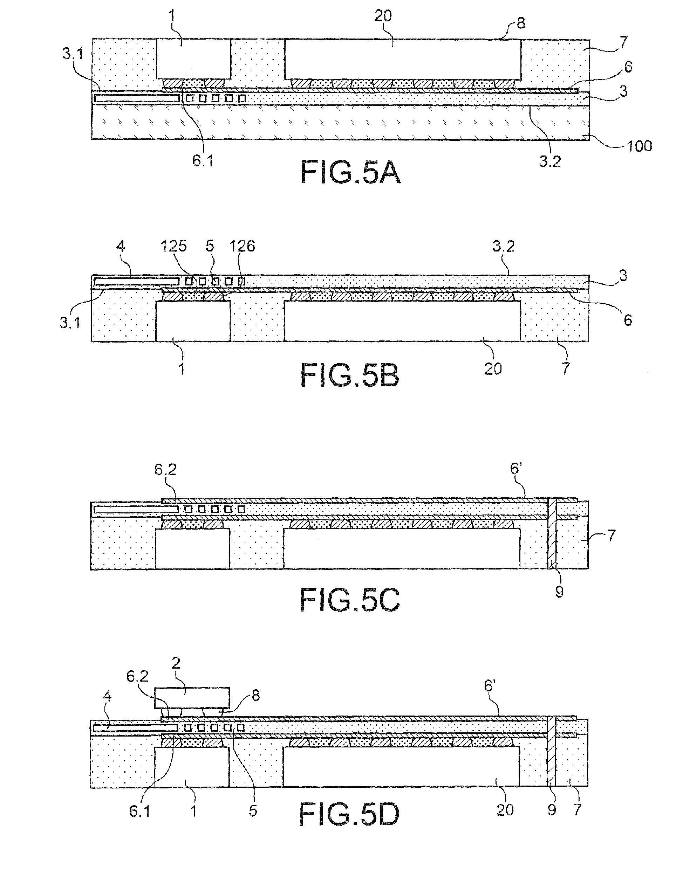

La figure 5A illustre une étape d'enrobage des composants 1, 20 assemblés sur la face libre 3.2 de la couche intermédiaire 3. Cet enrobage se fait avec un enrobé 7 par exemple de la résine. L'enrobé 7 recouvre la face libre 3.1 de la couche intermédiaire et entoure le composant 1 et le dispositif de pilotage 20. Cet enrobé 7 va contribuer à rigidifier la couche intermédiaire 3 de manière à pouvoir mettre à nu son autre face principale 3.2 en éliminant le substrat de base 100. Si le substrat de base 100 est en silicium, son retrait peut se faire par gravure chimique sélective avec arrêt sur la couche intermédiaire 3 (figure 5B). Sur la face principale 3.2 mise à nu de la couche intermédiaire 3, on va réaliser par exemple de la même manière que décrit précédemment des pistes de connexion électrique 6' se terminant par des plots 6.2 pour accueillir l'autre composant optoélectronique 2 (figure 5C). Ces plots 6.2 peuvent être pourvus de billes fusibles 8 comme on l'a décrit précédemment. En variante, les billes fusibles 8 pourraient être solidaires du composant 2 au lieu d'être solidaires de la couche intermédiaire 3. On va ensuite solidariser l'autre composant optoélectronique 2 aux endroits prévus (figure 5D).

Il est possible de prévoir une interconnexion entre les pistes de connexion électrique 6 de l'une des faces principales 3.1 de la couche intermédiaire 3 et les pistes de connexion électrique 6' de l'autre face principale 3.2 de la couche intermédiaire 3. Cette interconnexion peut se faire par des trous métallisés 9 qui traversent l'épaisseur de la couche intermédiaire 3. Ces trous métallisés peuvent être formés avant l'étape d'enrobage (figure 4I) ou après l'étape de mise à nu de l'autre face principale 3.2 de la couche intermédiaire 3 (figure 5C). La réalisation de trous métallisés est classique en microélectronique. Sur les figures 5, seuls deux plots de connexion 6.1, 6.2 sont illustrés en bout des pistes de connexion électriques 6 et 6'.

Avec un tel procédé de réalisation, il est possible de fabriquer des dispositifs optoélectroniques de l'invention, de manière collective en utilisant les moyens habituels de la microélectronique et d'obtenir les précisions requises pour ce genre de dispositif optoélectronique.

Bien que plusieurs modes de réalisation de la présente invention aient été représentés et décrits de façon détaillée, on comprendra que différents changements et modifications puissent être apportés sans sortir du cadre de l'invention. On pourra notamment hybrider les composants optoélectroniques par tous moyens connus de l'homme de l'art.

## Revendications

1. Dispositif optoélectronique comportant au moins deux composants optoélectroniques (1, 2) qui coopèrent, parmi lesquels un premier qui est un laser à émission de lumière par la surface (1) et un autre composant optoélectronique (2), **caractérisé en ce que** chacun des composants optoélectroniques (1, 2) est monté sur une face principale (3.1, 3.2) différente et opposée d'une couche intermédiaire (3) incorporant un coupleur à réseau (5) couplé à un guide d'onde optique (4) destiné à véhiculer une partie de la lumière émise par le laser à émission par la surface (1), le coupleur à réseau (5) étant en sandwich entre la face émissive du laser à émission par la surface (1) et l'autre composant optoélectronique (2).

2. Dispositif optoélectronique selon la revendication 1, dans lequel l'autre composant optoélectronique (2) est un photodétecteur de surveillance de la lumière émise par le laser (1).

3. Dispositif optoélectronique selon la revendication 1, dans lequel l'autre composant optoélectronique (2) est un émetteur.

4. Dispositif optoélectronique selon l'une des revendications 1 à 3, dans lequel le coupleur à réseau (5) est semi-transparent pour la lumière émise par le laser à émission par la surface (1).

5. Dispositif optoélectronique selon l'une des revendications précédentes, dans lequel la couche intermédiaire (3) est flanquée sur chacune des ses faces principales (3.1, 3.2) de pistes de connexion électrique (6, 6').

6. Dispositif optoélectronique selon la revendication 5, dans lequel au moins une piste de connexion électrique (6) se termine par un plot (6.1) doté d'une bille fusible (8) avant le montage du laser (1) ou de l'autre composant optoélectronique (2).

7. Dispositif optoélectronique selon l'une des revendications 5 ou 6, dans lequel une piste de connexion électrique (6) d'une face (3.1) est reliée à une piste de connexion électrique (6') de l'autre face (3.2) par au moins un trou métallisé (9) traversant la couche intermédiaire (3).

8. Dispositif optoélectronique selon l'une des revendications précédentes, dans lequel un boîtier (10) loge la couche intermédiaire (3) et au moins une paire formée du laser (1) et de l'autre composant optoélectronique (2).

9. Dispositif optoélectronique selon la revendication 8, lorsque plusieurs paires sont logées dans le boîtier (10), les composants optoélectroniques (1) montés sur une face de la couche intermédiaire (3) sont individuels ou regroupés en barrette (11).

10. Procédé de réalisation d'un dispositif optoélectronique comportant au moins deux composants optoélectroniques (1, 2) qui coopèrent parmi lesquels un premier qui est un laser à émission de lumière par la surface (1) et un autre composant optoélectronique (2) comportant les étapes suivantes :
- réalisation sur un substrat de base (100) d'une couche intermédiaire (3) incorporant un coupleur à réseau (5) couplé à un guide d'onde optique (4) et ayant une face principale libre (3.1),
- réalisation de pistes de connexion électrique (6) sur la face principale libre (3.2) de la couche intermédiaire (3),
- assemblage de l'un des deux composants optoélectroniques (1) sur la face principale libre (3.1) de la couche intermédiaire (3) en le plaçant au niveau du coupleur de réseau (5) et en le reliant électriquement aux pistes de connexion électrique (6),
- dépôt d'un enrobé (7) sur la face principale libre (3.1) de la couche intermédiaire (3) englobant le composant optoélectronique (1) assemblé,
- élimination du substrat de base (100) mettant à nu une autre face principale (3.2) de la couche intermédiaire (3),
- réalisation de pistes de connexion électrique (6') sur la face principale (3.2) mise à nu de la couche intermédiaire (3),
- assemblage de l'autre composant optoélectronique (2) sur la face principale (3.2) mise à nu de la couche intermédiaire (3) en le plaçant au niveau du coupleur de réseau (5) et en le reliant électriquement aux pistes de connexion électrique (6') de la face principale (3.2) mise à nu.

11. Procédé selon la revendication 10, dans lequel l'assemblage se fait par connexion par billes fusibles (8), par thermo-compression de plots (126) ou par collage avec de la colle conductrice.

12. Procédé selon la revendication 11, dans lequel de la colle (125) est insérée entre la couche intermédiaire (3) et l'un au moins des composants optoélectroniques (1, 2).

13. Procédé selon l'une des revendications 10 à 12, dans lequel le coupleur à réseau (5) et le guide d'onde optique (4) sont réalisés en surface du substrat de base (100).

14. Procédé selon l'une des revendications 10 à 13, dans lequel le guide d'onde optique (4) a un coeur (102) qui est réalisé tout comme le coupleur à réseau (5) en silicium, silice dopée, matériau obtenu par sol-gel, résine, polymère.

15. Procédé selon l'une des revendications 10 à 14, dans lequel l'élimination du substrat de base (100) se fait par gravure chimique sélective.
